# DEMANDE DE BREVET EUROPEEN

(11) **EP 3 843 249 A1**
(43) Date de publication de la demande: **30.06.2021**
(21) Numéro de dépôt: 21152700.7
(22) Date de dépôt: 21.01.2021
(51) Int. Cl.: H02K 11/05

(54) **MODULE ELECTRONIQUE POUR MACHINE ELECTRIQUE TOURNANTE**

(30) Priorité: 27.12.2019 FR 1915660
(71) Demandeur: VALEO EQUIPEMENTS ELECTRIQUES MOTEUR, 94046 Créteil Cedex (FR)
(72) Inventeur: FAVEROLLE, Pierre, 94046 CRETEIL CEDEX (FR); MASSON, Philippe, 38070 ST QUENTIN FALLAVIER (FR); FANG, Ruyi, 94046 CRETEIL CEDEX (FR)
(74) Mandataire: Prigent, Pierre

(57) **Abrégé**

L'invention concerne un module électronique (36) pour machine électrique tournante (10) comprenant :
- un boitier (40) comprenant un fond (41),
- un ensemble de modules de puissance, monté sur le fond (41) du boitier, apte à redresser un système de courant polyphasé en provenance des phases d'un stator de la machine électronique et éventuellement, apte à alimenter en un système de courant polyphasé les phases du stator,
- une borne positive (43) et une borne négative (44) pour alimenter en courant l'ensemble de modules de puissance, la borne positive étant reliée électriquement à l'ensemble de modules de puissance par une trace positive (45) disposée à distance du fond du boitier, la borne négative étant reliée électriquement à l'ensemble de modules par une trace négative (46) disposée à distance du fond du boitier,
caractérisé la trace négative et la trace positive sont superposées l'une sur l'autre au moins partiellement.

## Description

### DOMAINE TECHNIQUE DE L'INVENTION

La présente invention concerne un module électronique pour alimenter machine électrique tournante de véhicule, notamment automobile et une machine électrique équipé d'un tel module.

L'invention trouve des applications dans le domaine des machines électriques tournantes telles que les alternateurs, les alterno-démarreurs, dont les tensions sont par exemple supérieures à 48V.

### ARRIERE-PLAN TECHNOLOGIQUE DE L'INVENTION

Il est connu dans le domaine technique d'utiliser un ensemble de modules de puissances comprenant des interrupteurs électroniques de type MOSFET pour redresser, en mode générateur, un système de courant polyphasé en provenance de phases du stator de la machine électrique et pour alimenter les mêmes phases de ce stator en mode moteur.

Chacun de ces modules de puissances est connecté électriquement à l'une des phases du stator et à l'une des deux bornes d'alimentation B+ et B-.

Ces bornes d'alimentation du module électronique sont reliées électriquement à la batterie et doivent être reliées électriquement aux modules de puissance. Des traces positive et négative parcourant un boitier du module électronique dans lequel sont logés les modules de puissance sont prévues pour leur distribuer du courant.

Ces modules de puissance, du fait de leur commutation, sont responsables de l'élévation de la température dans le boitier. Il est connu de monter sur un fond du boitier afin de dissiper la chaleur à l'extérieur. Dans EP1556940A1, la surface extérieure du boitier comporte des ailettes afin d'améliorer la surface d'échange entre l'intérieur et l'extérieur du boitier. Il est également connu de l'art antérieur des modules électronique refroidi par eau. Néanmoins, ces solutions ne sont que curatives.

Il existe un besoin de disposer d'un module électronique dont les modules de puissance présentent un échauffement limité.

### RESUME DE L'INVENTION

La présente invention vise à remédier efficacement à ces inconvénients en proposant un module électronique pour machine électrique tournante comprenant :
- un boitier comprenant un fond,
- un ensemble de modules de puissance, monté sur le fond du boitier, apte à redresser un système de courant polyphasé en provenance de phases d'un stator de la machine électronique et éventuellement, apte à alimenter en un système de courant polyphasé les phases du stator,
- une borne positive et une borne négative pour alimenter en courant l'ensemble de modules de puissance, la borne positive étant reliée électriquement à l'ensemble de modules de puissance par une trace positive disposée à distance du fond du boitier, la borne négative étant reliée électriquement à l'ensemble de modules de puissance par une trace négative disposée à distance du fond du boitier, caractérisé en ce que la trace négative et la trace positive sont superposées l'une sur l'autre au moins partiellement.

La superposition des traces positive et négative, dites aussi trace B+ et trace B-, permet de réduire les inductances de ces traces. Cela permet d'augmenter la vitesse de commutation des modules de puissance et ainsi de réduire les pertes en commutation. L'échauffement de ces modules de puissance est ainsi réduit.

Les traces à distance du fond ne reposent pas sur ledit fond.

Les modules de puissance peuvent être disposés axialement entre les fond et les traces B+ et B-, cela permet un meilleur refroidissement des modules de puissance, notamment grâce à une meilleure réparation structurelle. On utilise aussi au mieux la dimension axiale du boitier.

Selon un aspect de l'invention, les traces négative et positive peuvent être surmoulées. Une enveloppe en matériau isolant, notamment en plastique entoure un matériau conducteur, par exemple en cuivre. Les traces positive et négative peuvent être à section rectangulaire.

Selon un aspect de l'invention, le fond peut être sensiblement plan. Le plan peut être normal à un axe du module définissant la direction axiale. Le fond peut être sensiblement circulaire, notamment sensiblement circulaire autour de l'axe du module. L'axe du module peut être parallèle, notamment confondu, avec un axe de rotation de la machine électrique dans lequel le module électronique peut être disposé.

Le fond peut présenter une surface intérieure au boitier et une surface extérieure, apte à être en regard d'un stator de la machine dans laquelle peut être intégré ce module électronique. L'épaisseur du fond peut être comprise entre 5mm et 20mm. Le fond permet d'évacuer la chaleur générée par les modules de puissance en fonctionnement.

Selon un aspect de l'invention, il peut y avoir superposition quand une droite de direction axiale traverse chacune des traces.

Selon un aspect de l'invention, une trace est à distance du fond signifie qu'il existe au moins localement un espace, notamment dans la direction axiale, entre la trace et le fond.

La trace positive ou la trace négative peut s'étendre dans un plan parallèle au fond. Les traces positive et négative peuvent être en contact plan l'une sur l'autre. En variante, il existe un espace inférieur dont la longueur axialement est inférieure à celle de l'une des traces. La distance axiale entre les traces et le fond peut être supérieure à deux fois l'épaisseur axiale de l'une des traces, en particulier trois fois supérieure, en particulier quatre fois supérieure.

Selon un aspect de l'invention, les traces positive et négative peuvent être superposées sur plus de la moitié de la longueur de l'une des deux traces, notamment sur plus de 75%, notamment sur plus de 90%. La longueur est la somme des longueurs de tronçons rectilignes des traces.

Selon un aspect de l'invention, la trace positive peut être disposée axialement entre le fond et la trace négative. En variante, trace négative est disposée axialement entre le fond et la trace positive.

Selon un aspect de l'invention, les traces positive et négative s'étendent linéairement. Par opposition à une trace qui serait surfacique qui s'étend dans plusieurs directions. Linéairement signifie que la direction d'extension est prépondérante sur les deux autres directions.

Selon un aspect de l'invention, l'une des deux traces positive et négative est coudée et l'autre est rectiligne. La trace coudée peut comprendre au moins deux portions rectilignes formant un coude en leur intersection. L'angle du coude mesuré entre les portions rectilignes peut être inférieur à 60 degrés, de préférence inférieur à 45 degrés. Le coude peut présenter une forme arrondie. Le coude peut être traversé par l'axe du module. Ces deux portions peuvent s'étendre radialement. La trace coudée peut présenter uniquement deux portions rectilignes.

Selon un aspect de l'invention, la trace positive est rectiligne et la trace négative est coudée. En variante, la trace positive est coudée et la trace négative est rectiligne.

En variante, chacune des traces peut être coudée. En variante encore, tout ou partie des deux traces peut présenter une forme globalement arrondie.

Les traces positives et négatives peuvent se séparer l'une de l'autre dans une zone centrale du boitier, zone centrale qui peut être centrée sur l'axe du boitier.

Selon un aspect de l'invention, le boitier peut comprendre une paroi sensiblement cylindrique s'étendant depuis le fond. Les bornes positive et négative peuvent être ménagées dans une première zone de cette paroi. La trace positive peut s'étendre depuis la première zone jusqu'à atteindre une deuxième zone de la paroi. La trace négative peut s'étendre depuis la première zone jusqu'à atteindre une troisième zone de la paroi, éloigné de la deuxième zone. Chaque trace peut donc s'étendre d'un bord du boitier à un autre bord du boitier en passant en son centre.

La deuxième zone peut être sensiblement à équidistance des première et troisième zones.

La paroi peut être partiellement non conductrice électriquement, de préférence totalement non conductrice. La paroi peut être continue. La paroi peut s'étendre axialement au-delà des traces positive et négative. La paroi est sensiblement cylindrique.

Selon un aspect de l'invention, le module électronique peut comprendre, plusieurs connexions de phase, en particulier trois, chacune apte à être connectée à une phase de stator. L'ensemble de modules de puissance peut comprendre, pour chaque connexion de phase, au moins un module positif relié électriquement à la borne positive et à la connexion de phase, au moins un module négatif relié électriquement à la borne négative et à la connexion de phase.

Le système de courant peut donc être triphasé. L'ensemble des modules de puissance positif forme un demi-pont positif. L'ensemble des modules de puissance négatif forme un demi-pont négatif. Les connexions de phase permettent d'amener les phases de l'extérieur du boitier à l'intérieur en traversant la paroi.

Selon un aspect de l'invention, les modules de puissance peuvent être des interrupteurs pilotés, par exemple de type MOSFET.

Selon un aspect de l'invention, Chaque connexion de phase peut traverser la paroi. Les première, deuxième et troisième zones associées aux traces positive et négative sont alternées avec les zones de connexion de phase. Il y a alternance entre traces positive et négative d'une part et connexions de phase d'autre part lorsque l'on parcourt circonférentiellement la paroi.

Pour chaque connexion de phase, l'ensemble de modules de puissance peut comprendre deux modules positifs et deux modules négatifs, respectivement trois positifs et trois négatifs.

Selon un autre aspect de l'invention, le module électronique peut comprendre une deuxième trace positive et une deuxième trace négative montées sur le fond et isolées électriquement dudit fond. La deuxième trace positive peut relier électriquement la trace positive et tout ou partie des modules de puissance positifs. La deuxième trace négative peut relier électriquement la trace négative et tout ou partie des modules de puissance négatifs.

Chaque deuxième trace positive et négative peut s'étendre circonférentiellement, notamment depuis la deuxième ou la troisième zone.

Une première couche isolante peut être prévue entre chaque deuxième trace positive et négative et le fond pour éviter le contact électrique.

Chaque trace positive et négative peut être en contact surfacique avec la trace associée pour le passage du courant.

Chaque trace positive et négative peut être fixée par vissage à la deuxième trace associée. Un premier organe de fixation, par exemple une vis, peut être vissé dans chaque trace positive ou négative, dans la deuxième trace associée et dans le fond du boitier. Une première protubérance peut être prévue à l'extérieur du boitier pour recevoir le premier organe de fixation. Chaque première protubérance peut venir de matière avec le fond du boitier. Chaque première protubérance peut prendre la forme d'un plot.

Selon un aspect de l'invention, le contact électrique entre une trace et une deuxième trace se fait par contact surfacique, notamment uniquement par ce contact surfacique. Le premier organe de fixation associé ne conduit pas le courant.

Selon un aspect de l'invention, tout ou partie des modules positifs est monté sur la deuxième trace positif.

Selon un aspect de l'invention, pour chacune des connexions de phase, une trace de phase peut être montée sur le fond pour relier électriquement la connexion de phase et les modules de puissance associées à cette connexion de phase.

Selon un aspect de l'invention, chaque trace de phase peut être disposé axialement entre une des connexions de phase et le fond.

Chaque trace de phase peut être fixée par vissage à connexion de phase associée. Un organe de fixation, par exemple une vis, peut être vissé dans chaque connexion de phase, dans la trace de phase associée et dans le fond du boitier. Une protubérance peut être prévue à l'extérieur du boitier pour recevoir l'organe de fixation. Chaque protubérance peut venir de matière avec le fond du boitier. Chaque protubérance peut prendre la forme d'un plot.

Selon un aspect de l'invention, une couche isolante peut être prévue entre chaque trace de phase et le fond pour éviter le contact électrique. Les premières couches isolantes et/ou les couches isolantes peuvent présenter une épaisseur inférieur ou égale à 200 microns, notamment inférieur à 150 microns.

Selon un aspect de l'invention, tout ou partie des modules négatifs associées à cette connexion de phase est monté sur la trace de phase.

Selon un aspect de l'invention, le contact électrique entre chaque connexion de phase et une deuxième trace se fait par contact surfacique, notamment uniquement par ce contact surfacique. L'organe de fixation associé ne conduit pas le courant.

Selon un aspect de l'invention, la deuxième trace positive, la deuxième trace négative et les traces de puissance peuvent appartenir à une carte électronique commune. Cette carte peut être fixé au fond du boitier par les premiers organes de fixation et les organes de fixation. Les traces sont isolées les unes des autres par un matériau isolant de la carte électronique. L'assemblage des traces dans le boitier en est simplifié.

Selon un aspect de l'invention, le module peut comprendre une unité de commande de l'ensemble de modules de puissance. Le boitier peut comprendre un couvercle parallèle au fond dans lequel est ménagé un renfoncement. L'unité de commande peut être disposée dans ce renfoncement. Disposer l'unité de commande dans un renfoncement permet de dissiper efficacement la chaleur dégagée par l'unité de commande car la surface d'échange est augmentée. Le renfoncement peut présenter une forme sensiblement carré. L'unité de commande peut être totalement logée dans le renfoncement. En variante, elle peut être uniquement partiellement dans le renfoncement.

Selon un aspect de l'invention, les traces positive et négative sont disposées axialement entre le fond et le couvercle. La paroi, le fond et le couvercle peuvent définir un espace fermé. Le couvercle peut être scellé sur la paroi, notamment à la l'aide d'une colle, une fois tous les composants électroniques placés dans l'espace fermé.

L'invention se rapporte également à une machine électrique tournante comprenant un stator fixe en rotation comprenant une pluralité de phases, un rotor apte à tourner autour d'un axe de rotation de la machine et un module électronique tel que décrit précédemment. Le module électronique est fixe par rapport au stator.

L'axe de rotation de la machine peut être confondu axe l'axe du module. Dans ce cas, le module électronique est disposé axialement d'un côté du stator.

En variante, ces deux axes peuvent être sensiblement perpendiculaire l'un à l'autre. Le module électronique est disposé radialement à l'extérieur du stator.

Chaque phase du stator peut être connectée à une connexion de phase du module électronique.

### BREVE DESCRIPTION DES FIGURES

D'autres avantages et caractéristiques de l'invention apparaîtront à la lecture de la description, illustrée par les figures dans lesquelles :
- [Fig.1] La figure 1 représente une vue schématique en coupe d'une machine électrique équipée d'un module électronique selon l'invention ;

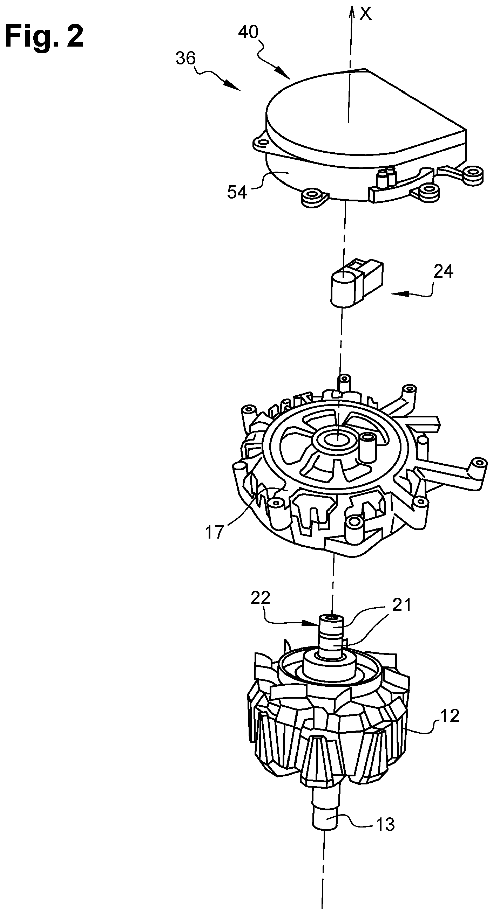

- [Fig. 2] La figure 2 représente, schématiquement et partiellement, une vue en pièce détachée d'une partie de la machine de la figure 1 ;
- [Fig. 3] La figure 3 représente, schématiquement et partiellement, de face du corps d'un module électronique selon l'invention;
- [Fig. 4] La figure 4 représente, schématiquement et partiellement, un détail du module électronique selon l'invention,

### DESCRIPTION DETAILLEE

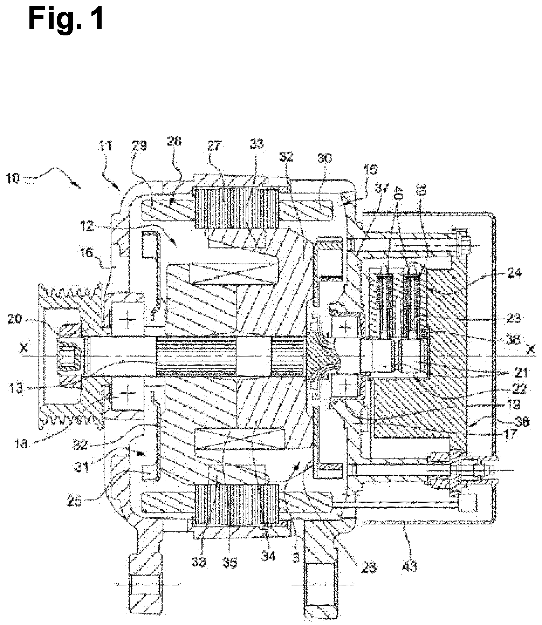

La figure 1 représente une machine électrique tournante 10 polyphasée, notamment pour véhicule automobile. Cette machine électrique tournante 10 transforme de l'énergie mécanique en énergie électrique, en mode alternateur, et peut fonctionner en mode moteur pour transformer de l'énergie électrique en énergie mécanique. Cette machine électrique tournante 10 est, par exemple, un alternateur, un alterno-démarreur ou une machine réversible.

La machine électrique tournante 10 comporte un carter 11. A l'intérieur de ce carter 11, elle comporte, en outre, un arbre 13, un rotor 12 solidaire en rotation de l'arbre 13 et un stator 15 entourant le rotor 12. Le stator et le carter sont fixes en rotation. Le mouvement de rotation du rotor 12 se fait autour d'un axe de rotation de la machine X.

Dans cet exemple, le carter 11 comporte un palier avant 16 et un palier arrière 17 qui sont assemblés ensemble. Ces paliers 16, 17 sont de forme creuse et portent, chacun, centralement un roulement à billes 18, 19 respectif pour le montage à rotation de l'arbre 13.

Une poulie 20 est fixée sur une extrémité avant de l'arbre 13, au niveau du palier avant 16, par exemple à l'aide d'un écrou en appui sur le fond de la cavité de cette poulie. Cette poulie 20 permet de transmettre le mouvement de rotation à l'arbre 13 ou à l'arbre 13 de transmettre son mouvement de rotation à la courroie.

L'extrémité arrière de l'arbre 13 porte un collecteur 22. Ce collecteur comporte un corps réalisé en matériau électriquement isolant et des bagues collectrices 21 surmoulées dans ledit corps. Les bagues collectrices 21 ont une forme annulaire et sont entrainées en rotation avec le rotor 12. Des balais 23 appartenant à un porte-balai 24 sont disposés de façon à frotter sur les bagues collectrices 21. Le porte-balai 24 est relié électriquement à un ensemble électronique 36 pilotant la tension appliquée aux balais.

Le palier avant 16 et le palier arrière 17 peuvent comporter, en outre, des ouvertures sensiblement latérales pour le passage de l'air en vue de permettre le refroidissement de la machine électrique tournante par circulation d'air engendrée par la rotation d'un ventilateur avant 25 sur la face axiale avant du rotor 12, c'est-à-dire au niveau du palier avant 16 et d'un ventilateur arrière 26 sur la face axiale arrière du rotor, c'est-à-dire au niveau du palier arrière 17. Alternativement, les paliers pourront comporter des conduits permettant le passage d'un liquide de refroidissement.

Dans cet exemple, le rotor 12 est un rotor à griffe. Il comporte deux roues polaires 31. Chaque roue polaire 31 est formée d'un flasque 32 et d'une pluralité de griffes 33 formants des pôles magnétiques. Le flasque 32 est d'orientation transversale et présente, par exemple, une forme sensiblement annulaire. Ce rotor 12 comporte, en outre, un noyau 34 cylindrique qui est intercalé axialement entre les roues polaires 31. Ici, ce noyau 34 est formé de deux demi noyaux appartenant chacun à l'une des roues polaires. Le rotor 12 comporte, entre le noyau 34 et les griffes 33, une bobine 35 comportant, ici, un moyeu de bobinage et un bobinage électrique sur ce moyeu. Par exemple, les bagues collectrices 21 appartenant au collecteur 22 sont reliées par des liaisons filaires à ladite bobine 35. Le rotor 12 peut également comporter des éléments magnétiques interposés entre deux griffes 33 adjacentes.

Dans cet exemple de réalisation, le stator 15 comporte un corps 27 en forme d'un paquet de tôles doté d'encoches, par exemple du type semi fermée ou ouverte, équipées d'isolant d'encoches pour le montage d'un bobinage électrique 28. Ce bobinage 28 traverse les encoches du corps 27 et forment un chignon avant 29 et un chignon arrière 30 de part et d'autre du corps du stator. Le bobinage 28 est connecté, par exemple, en étoile ou encore en triangle.

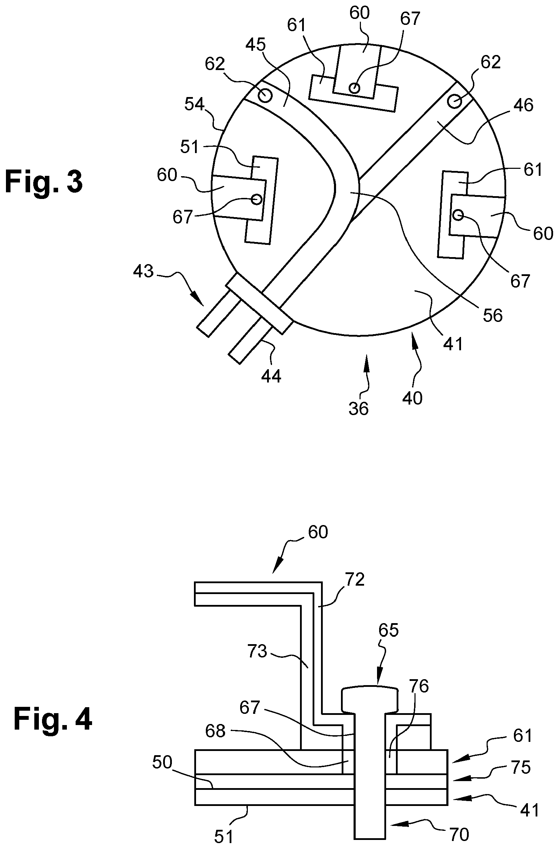

Par ailleurs, le bobinage 28 est formé d'une ou plusieurs phases, ici trois phases. Chaque phase comporte au moins un conducteur traversant les encoches du corps de stator 27 et forme, avec toutes les phases, les chignons. Le bobinage 28 est relié électriquement à un module électronique 36 fixe par rapport au stator et décrit plus en détail en référence aux figures 3 et 4.

Dans cet exemple considéré, le module électronique 36 comprend un boitier 40 comprenant un fond 41, un ensemble de modules de puissance, monté sur le fond du boitier, apte à redresser un système de courant polyphasé en provenance de phases du stator 15 et apte à alimenter en un système de courant polyphasé les phases.

Dans l'exemple considéré, le fond 41 est sensiblement plan et normal à un axe du module, confondu avec l'axe de la machine électrique 10. Le fond est sensiblement circulaire, autour de l'axe du module.

Le fond présente une surface intérieure 50 au boitier 40 et une surface extérieure 51 en regard du stator 15. L'épaisseur du fond peut être comprise entre 5mm et 20mm.

Dans l'exemple considéré, le boitier comprend également une paroi 54, continue, sensiblement cylindrique s'étendant depuis le fond 41 dans la direction opposée au stator 15. La paroi 54 est ici non conductrice. La paroi s'étend axialement au-delà des traces positive et négative.

Bien que non représentée, le boitier comprend également une unité de commande de l'ensemble de modules de puissance et un couvercle parallèle au fond dans lequel est ménagé un renfoncement. L'unité de commande est disposée dans ce renfoncement. Le renfoncement peut présenter une forme sensiblement carré.

Dans l'exemple considéré, la paroi 54, le fond 41 et le couvercle définissent un espace fermé. Le couvercle peut être scellé sur la paroi 54, une fois tous les composants électroniques placés dans l'espace fermé.

Le module électronique 36 comprend également une borne positive 43 et une borne négative 44 pour alimenter en courant l'ensemble de modules de puissance La borne positive 43 est reliée électriquement à l'ensemble de modules de puissance par une trace positive disposée 45 à distance du fond 41 du boitier. La borne négative 44 étant reliée électriquement à l'ensemble de modules de puissance par une trace négative 46 disposée à distance du fond du boitier.

Dans l'exemple considéré la trace positive et la trace négative sont superposées l'une sur l'autre au moins partiellement. Ici sur plus de la moitié de la longueur de la trace négative 46.

Les traces positive 45 et négative 46 sont disposées axialement entre le fond 41 et le couvercle. Plus précisément ; la trace négative 46 est ici disposée entre le fond 41 et la trace positive 45.

Les traces positive 45 et négative 46 sont surmoulées. Une enveloppe en matériau isolant, notamment en plastique, entoure un matériau conducteur, par exemple en cuivre. Les traces positive et négative sont ici à section rectangulaire.

Dans l'exemple considéré, la trace positive 45 et la trace négative 46 s'étendent dans un plan parallèle au fond 41 et sont en contact plan l'une sur l'autre. La distance axiale entre la trace négative 46 et le fond peut être supérieure à deux fois l'épaisseur axiale de l'une des traces.

Dans l'exemple considéré, la trace positive 45 est coudée et la trace négative est rectiligne. La trace positive comprend deux portions rectilignes d'extension radiale formant un coude en leur intersection. L'angle du coude mesuré entre les portions rectilignes est inférieur à 60 degrés, sensiblement égale à 45 degrés. Le coude 56 présente une forme arrondie et traverse l'axe X.

Dans l'exemple considéré, Les bornes positive 41 et négative 42 sont ménagées dans une première zone de cette paroi.la trace positive 45 s'étend depuis la première zone jusqu'à atteindre une deuxième zone de la paroi. La trace négative 46 s'étend depuis la première zone jusqu'à atteindre une troisième zone de la paroi, éloigné de la deuxième zone. Chaque trace s'étend donc d'un bord du boitier 41 à un autre bord du boitier en passant en son centre. La deuxième zone est ici sensiblement à équidistance des première et troisième zones.

Dans l'exemple considéré, le module électronique 36 comprend, trois connexions de phase 60, chacune apte à être connectée à une phase du bobinage 28 du stator 15. Chaque connexion de phase 60 traverse la paroi 54 pour amener électriquement les phases de l'extérieur du boitier 40 à l'intérieur en traversant la paroi 54.

L'ensemble de modules de puissance comprend, pour chaque connexion de phase 60, au moins un, par exemple deux, module positif relié électriquement à la borne positive 43 et à la connexion de phase et au moins un, par exemple deux, module négatif relié électriquement à la borne négative 44 et à la connexion de phase 60. L'ensemble des modules de puissance positif forme un demi-pont positif. L'ensemble des modules de puissance négatif forme un demi-pont négatif. Les modules de puissance peuvent être des interrupteurs pilotés, par exemple de type MOSFET.

Dans l'exemple considéré, les première, deuxième et troisième zones associées aux traces positive 45 et négative 46 sont alternées avec les zones de connexion de phase 60.

Dans l'exemple considéré, le module électronique 36 comprend une deuxième trace positive et une deuxième trace négative montées sur le fond 41 et isolées électriquement dudit fond 41. Ces traces ne sont pas représentées sur les figures 3 et 4. La deuxième trace positive relie électriquement la trace positive 45 et tout ou partie des modules de puissance positifs. La deuxième trace négative relie électriquement la trace négative 46 et tout ou partie des modules de puissance négatifs. Chaque deuxième trace positive et négative peut s'étendre circonférentiellement, notamment depuis la deuxième ou la troisième zone. Une première couche d'isolant peut être prévue entre chaque deuxième trace positive et négative et le fond 41 pour éviter le contact électrique. Chaque trace positive et négative peut être en contact surfacique avec la trace associée pour le passage du courant.

Dans l'exemple considéré, chaque trace positive 45 et négative 46 peut être fixée par vissage à la deuxième trace positive ou négative associée. Un premier organe de fixation, par exemple une vis, peut être vissé dans chaque trace positive ou négative, dans la deuxième trace associée et dans le fond 41. Une première protubérance peut être prévue à l'extérieur du boitier pour recevoir le premier organe de fixation. Chaque première protubérance peut venir de matière avec le fond du boitier. Chaque première protubérance peut prendre la forme d'un plot. Les premiers organes de fixation traversent des premières ouvertures de vissage 62 des traces positive 45 et négative 46.

Dans l'exemple considéré, pour chaque connexion de phase 60, une trace de phase 61 est montée sur le fond 41 pour relier électriquement la connexion de phase 60 et les modules de puissance associées à cette connexion de phase.

Comme on peut le voir à la figure 4, chaque trace de phase 61 est disposée axialement entre le fond 41 et une des connexions de phase 60.

Dans l'exemple considéré, le module comprendre trois organes de fixation 65, qui sont par exemple des vis. Chaque organe de fixation est vissé dans une des connexions de phase 60, dans une des traces de phase 61 et dans le fond 41 du boitier. Un seul organe de fixation permet de mutualiser les fixations. Pour chaque connexion de phase 60 un unique organe de fixation 65 est prévu pour fixer la trace de phase 61 à la connexion de phase 60.

Dans l'exemple considéré, chaque connexion de phase 60 présente un trou 67 pour le passage de l'un des organes de fixation 65. Chaque trace de phase 61 présente également un trou 68 pour le passage de l'un des organes de fixation 65. Les trous de passage sont alignés deux à deux.

Dans l'exemple considéré, le boitier 40 comprend trois protubérances 70 recevant un organe de fixation 65. Chaque protubérance 70 est ménagée dans le fond 41 du boitier. Chaque protubérance 70 vient de matière avec le fond 41 du boitier et est disposée à l'extérieur du boitier 40. Chaque protubérance 70 prend ici la forme d'un plot tronconique. Les premières protubérances et les protubérances peuvent être identiques.

Dans l'exemple considéré, chaque connexion de phase 60 comprend une portion isolante 72 et une portion conductrice 73. La portion isolante 72 est en contact avec l'organe de fixation 65 et la portion conductrice 73 est en contact surfacique avec la trace de phase 61 pour relier électriquement la phase et la trace de phase 61. La portion conductrice n'est pas en contact avec l'organe de fixation 65.

Dans l'exemple considéré, une couche isolante 75 est prévue entre chaque trace de phase 60 et le fond 41 pour éviter le contact électrique. La couche isolante peut être mutualisée pour l'ensemble des phases 60. La couche ou les couches isolantes 75 peuvent présenter une épaisseur inférieure ou égale à 200 microns, notamment inférieure à 150 microns.

Dans l'exemple considéré, chaque trace de phase 61, peut être isolée de l'organe de fixation. Chaque trace de phase peut être isolée par un insert isolant 76 entourant l'organe de fixation 75. L'insert isolant 76 est ici indépendant. Chaque insert isolant 76 est monté dans une des ouvertures 68 des traces de phase 61.

En variante, chaque insert isolant 76 peut venir de matière avec la partie isolante de la connexion de phase. Chaque insert peut être une prolongation axiale en direction du fond.

En variante, chaque insert isolant 76 peut appartenir à la couche isolante. Chaque insert peut être une prolongation axiale en direction de la connexion de phase.

En variante encore, les organes de fixation peuvent être faits en matériau non conducteur électriquement, par exemple en plastique.

## Revendications

1. Module électronique (36) pour machine électrique tournante (10) comprenant :
- un boitier (40) comprenant un fond (41),
- un ensemble de modules de puissance, monté sur le fond (41) du boitier, apte à redresser un système de courant polyphasé en provenance des phases d'un stator de la machine électronique et éventuellement, apte à alimenter en un système de courant polyphasé les phases du stator,
- une borne positive (43) et une borne négative (44) pour alimenter en courant l'ensemble de modules de puissance, la borne positive étant reliée électriquement à l'ensemble de modules de puissance par une trace positive (45) disposée à distance du fond du boitier, la borne négative étant reliée électriquement à l'ensemble de modules par une trace négative (46) disposée à distance du fond du boitier,
**caractérisé en ce que** la trace négative et la trace positive sont superposées l'une sur l'autre au moins partiellement.

2. Module électronique (36) selon la revendication 1, **caractérisé en ce que** les traces positive (45) et négative (46) sont superposées sur plus de la moitié de la longueur de l'une des deux traces, notamment sur plus de 75%, notamment sur plus de 90%.

3. Module électronique (36) selon l'une des revendications 1 et 2, **caractérisé en ce que** le trace positive (45) est disposée axialement entre le fond (41) et la trace négative (46).

4. Module électronique (36) selon l'une quelconques des revendications précédentes, **caractérisé en ce que** l'une des deux traces positive et négative est coudée et l'autre est rectiligne.

5. Module électronique (36) selon l'une quelconques des revendications précédentes, le boitier (40) comprenant une paroi (54) sensiblement cylindrique s'étendant depuis le fond (41), les bornes positive et négative étant ménagées dans une première zone de cette paroi, la trace positive (45) s'étendant depuis la première zone jusqu'à atteindre une deuxième zone de la paroi, la trace négative (46) s'étendant depuis la première zone jusqu'à atteindre une troisième zone de la paroi, éloigné de la deuxième zone.

6. Module électronique (36) selon l'une quelconques des revendications précédentes, comprenant plusieurs connexions de phase (60), en particulier trois, chacune apte à être connectée à une phase de stator (15), l'ensemble de modules de puissance comprenant, pour chaque connexion de phase (60), au moins un module positif relié électriquement à la borne positive et à la connexion de phase, au moins un module négatif relié électriquement à la borne négative et à la connexion de phase.

7. Module électronique (36) selon la revendication précédente, comprenant une deuxième trace positive et une deuxième trace négative montées sur le fond (41) et isolées électriquement dudit fond, la deuxième trace positive reliant électriquement la trace positive (45) et tout ou partie des modules de puissance positifs, la deuxième trace négative (46) reliant électriquement la trace négative et tout ou partie des modules de puissance négatifs.

8. Module électronique selon l'une des revendications 6 ou 7, comprenant, pour chacune des connexions de phase (60), une trace de phase montée sur le fond pour relier électriquement la connexion de phase et les modules de puissance associées à cette connexion de phase.

9. Module électronique (36) selon l'une quelconque des revendications précédentes, le module comprenant une unité de commande de l'ensemble de modules de puissance, le boitier comprenant un couvercle parallèle au fond dans lequel est ménagé un renfoncement dans lequel est disposé l'unité de commande.

10. Machine électrique tournante (10) comprenant un stator (15) fixe en rotation comprenant une pluralité de phases, un rotor (12) apte à tourner autour d'un axe (X) et un module électronique (36) tel que décrit aux revendications 1 à 9, le module électronique étant fixe par rapport au stator.
